(19) Europäisches Patentamt
European Patent Office
Office européen des brevets

(11) **EP 4 411 808 A1**

(12) **EUROPEAN PATENT APPLICATION**
published in accordance with Art. 153(4) EPC

(43) Date of publication:
**07.08.2024 Bulletin 2024/32**

(21) Application number: **22876402.3**

(22) Date of filing: **28.09.2022**

(51) International Patent Classification (IPC):
**H01L 23/373** (2006.01)     **C08K 5/01** (2006.01)
**C08L 83/04** (2006.01)     **C09K 5/14** (2006.01)
**C08K 3/013** (2018.01)

(52) Cooperative Patent Classification (CPC):
**C08K 3/013; C08K 5/01; C08L 83/04; C09K 5/14;
H01L 23/373**

(86) International application number:
**PCT/JP2022/036313**

(87) International publication number:
**WO 2023/054536 (06.04.2023 Gazette 2023/14)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **29.09.2021 JP 2021160133**

(71) Applicant: **Sekisui Polymatech Co., Ltd.
Saitama-city, Saitama 338-0837 (JP)**

(72) Inventors:
• **UMETANI, Hiroshi**
  **Saitama-city, Saitama 338-0837 (JP)**
• **SEKI, Kazunori**
  **Saitama-city, Saitama 338-0837 (JP)**
• **KANEKO, Toshiki**
  **Saitama-city, Saitama 338-0837 (JP)**

(74) Representative: **Ter Meer Steinmeister & Partner
Patentanwälte mbB
Nymphenburger Straße 4
80335 München (DE)**

(54) **THERMALLY CONDUCTIVE SHEET**

(57)    A thermally conductive sheet including: a matrix formed of an organopolysiloxane; a thermally conductive filler included in the matrix; methyl phenyl silicone; and a hydrocarbon compound that is liquid at 25°C.

EP 4 411 808 A1

**Description**

Technical Field

The present invention relates to a thermally conductive sheet.

Background Art

In an electronic device such as a computer, an automotive part, or a cellphone, a heat-dissipating element such as a heat sink is generally used in order to dissipate heat generated from a heating element such as a semiconductor element or a machine part. It is known that a thermally conductive sheet is disposed between a heating element and a heat-dissipating element for the purpose of increasing the efficiency of heat transfer to the heat-dissipating element. The thermally conductive sheet is generally used by being compressed when disposed inside an electronic device, and because of this, high flexibility is required, and further in order to enhance the heat-dissipating property, it is necessary to increase the thermal conductivity.

In order to meet these needs, a thermally conductive material having high thermal conductivity and flexibility has been conventionally proposed, and for example, Patent Literature 1 proposes a putty-like heat-dissipating sheet containing silicone having a low crosslink density as a base resin and containing a thermally conductive filler in a large amount based on the base resin.

Citation List

Patent Literature

PTL1: JP 2005-042096 A

Summary of Invention

Technical Problem

However, in blending a thermally conductive filler in a large amount, when the base resin and the thermally conductive filler are mixed, these components are not sufficiently combined by the influence of the shortage of the base resin, and part of the thermally conductive filler may be left in a powdery state, or the like, therefore it may be difficult to form the thermally conductive composition into a sheet. In addition, even if it is possible to form the thermally conductive composition into a sheet, the thermally conductive fillers cannot be sufficiently combined, and for example, when the heat-dissipating sheet is peeled off from the release sheet, the heat-dissipating sheet may be damaged, or part of the heat-dissipating sheet may remain on the release sheet.

In order to deal with the above problem due to the shortage of the base resin, it is also conceivable to blend a plasticizer in a large amount, but this case has the following problem: when the thermally conductive material is contacted with an adherend, the plasticizer migrates to the adherend, and when the sheet is peeled off, the plasticizer remains as a residue on the adherend, which contaminates the adherend and reduces the reliability of the thermally conductive sheet.

Therefore, an object of the present invention is to provide a thermally conductive sheet being excellent in peelability and having less migration of a plasticizer to an adherend, while securing high thermal conductivity and good flexibility.

Solution to Problem

The present inventors have carried out diligent studies and as a result, found that the above problem can be solved by containing methyl phenyl silicone and a hydrocarbon compound that is liquid at 25°C, in a thermally conductive sheet including a matrix formed of an organopolysiloxane and a thermally conductive filler, and completed the present invention.

That is, the present invention provides the following [1] to [12].

[1] A thermally conductive sheet comprising: a matrix formed of an organopolysiloxane; a thermally conductive filler included in the matrix; methyl phenyl silicone; and a hydrocarbon compound that is liquid at 25°C.
[2] The thermally conductive sheet according to [1], wherein Fs/Fd, which is a ratio of a static load Fs to a dynamic load Fd, is less than 0.35.
[3] The thermally conductive sheet according to [1] or [2], wherein the hydrocarbon compound is liquid paraffin.

[4] The thermally conductive sheet according to any one of [1] to [3], wherein the methyl phenyl silicone is 5 to 100 parts by volume per 100 parts by volume of the matrix.

[5] The thermally conductive sheet according to any one of [1] to [4], wherein a content of the hydrocarbon compound is 1 to 80 parts by volume per 100 parts by volume of the matrix.

[6] The thermally conductive sheet according to any one of [1] to [5], further comprising dimethyl silicone oil.

[7] The thermally conductive sheet according to [6], wherein the dimethyl silicone oil is 2 to 100 parts by volume per 100 parts by volume of the matrix.

[8] A thermally conductive composition comprising an alkenyl group-containing organopolysiloxane, a hydrogen organopolysiloxane, a thermally conductive filler, methyl phenyl silicone, and a hydrocarbon compound that is liquid at 25°C.

[9] The thermally conductive composition according to [8], wherein the hydrocarbon compound is liquid paraffin.

[10] The thermally conductive composition according to [8] or [9], further comprising dimethyl silicone oil.

[11] A thermally conductive sheet laminated body comprising the thermally conductive sheet according to any one of [1] to [7] and a release sheet attached to at least one side of the thermally conductive sheet.

[12] An electronic device comprising the thermally conductive sheet according to any one of [1] to [7] interposed between a heating element and a heat-dissipating element.

Advantageous Effects of Invention

According to the present invention, it is possible to provide a thermally conductive sheet being excellent in peelability and having less migration of a plasticizer to an adherend, while securing high thermal conductivity and good flexibility.

Brief Description of Drawing

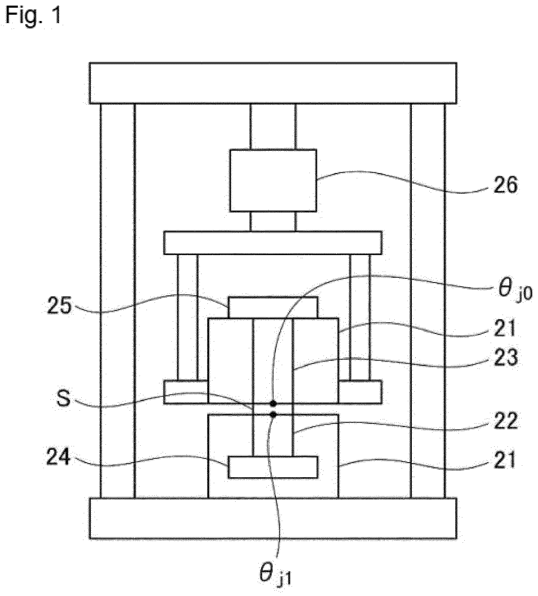

[Fig. 1] Fig. 1 is a schematic diagram of a thermal resistance measuring instrument.

Description of Embodiments

[Thermally conductive sheet]

The thermally conductive sheet of the present invention includes: a matrix formed of an organopolysiloxane; a thermally conductive filler; methyl phenyl silicone; and a hydrocarbon compound that is liquid at 25°C. Hereinafter, each component of the thermally conductive sheet will be described in detail.

<Matrix>

The thermally conductive sheet in the present invention includes a matrix formed of an organopolysiloxane. The organopolysiloxane may be of either the condensation reaction type or the addition reaction type, and the addition reaction type is preferable because this type is easy to highly fill with a thermally conductive filler, and the curing temperature can be easily adjusted with a catalyst or the like. The matrix can be obtained, for example, by curing a curable silicone composition. The curable silicone composition may be composed of, for example, a base resin and a curing agent.

The curable silicone composition preferably contains an alkenyl group-containing organopolysiloxane as a base resin and a hydrogen organopolysiloxane as a curing agent from the viewpoint of facilitating high filling with a thermally conductive filler in the case of an addition reaction type.

The curable silicone composition is preferably liquid before curing. When the curable silicone composition is liquid before curing, it is easy to highly fill the same with a thermally conductive filler and it is easy to disperse a hydrocarbon compound in the curable silicone composition. As used herein, the term "liquid" refers to a liquid at normal temperature (23°C) and 1 atmosphere.

By including an alkenyl group-containing organopolysiloxane and a hydrogen organopolysiloxane as a matrix, both undergo an addition reaction to form a crosslinked product, making it possible to obtain a thermally conductive sheet that is excellent in shape retainability and handleability.

As the alkenyl group-containing organopolysiloxane, an organopolysiloxane having at least a dimethylsiloxane unit can be used. Specific examples of the alkenyl group-containing organopolysiloxane include a vinyl-both terminated organopolysiloxane such as vinyl-both terminated polydimethylsiloxane, a vinyl-both terminated dimethylsiloxane-diphenylsiloxane copolymer, a vinyl-both terminated dimethylsiloxane-methyl phenyl siloxane copolymer, or a vinyl-both terminated dimethylsiloxane-diethylsiloxane copolymer.

The hydrogen organopolysiloxane is a compound having two or more hydrosilyl groups (SiH), and can cure an alkenyl group-containing organopolysiloxane as a base resin.

In addition, the matrix is preferably three-dimensionally crosslinked in order to be able to secure the shape retainability of the thermally conductive sheet. For this purpose, for example, in the case of an addition reaction type, a curable silicone composition containing at least an alkenyl group-containing organopolysiloxane having at least 3 or more alkenyl groups in one molecule or a hydrogen organopolysiloxane having at least 3 or more hydrogen atoms to be added to a silicon atom may be cured. Among these, a curable silicone composition containing at least a hydrogen organopolysiloxane having at least 3 or more hydrogen atoms to be added to a silicon atom is preferable.

The lower limit of the content of the matrix is preferably 3% by volume or more, more preferably 4% by volume or more, and further preferably 5% by volume or more, based on the total amount of the thermally conductive sheet. On the other hand, the upper limit of the content of the matrix is preferably 30% by volume or less, more preferably 20% by volume or less, and further preferably 15% by volume or less, based on the total amount of the thermally conductive sheet.

In addition, the content of the matrix is preferably 3 to 30% by volume, more preferably 4 to 20% by volume, and further preferably 5 to 15% by volume, based on the total amount of the thermally conductive sheet. When the content of the matrix is equal to or more than these lower limit values, it is easy to form a thermally conductive sheet, and when the content is equal to or less than these upper limit values, the content of the thermally conductive filler can be increased, and the thermal resistance value of the thermally conductive sheet obtained can be reduced.

As used herein, the range shown by "to" means a range of not less than a predetermined numerical value and not more than a predetermined numerical value that are shown before and after "to."

<Thermally conductive filler>

The thermally conductive sheet contains a thermally conductive filler. The thermally conductive filler is contained in a state of being dispersed in the matrix. By containing the thermally conductive filler in a state of being dispersed in the matrix, the thermally conductive property of the thermally conductive sheet can be enhanced, and the heat-dissipating property thereof can be enhanced. The thermally conductive filler may be a non-anisotropic filler, an anisotropic filler, or a combination thereof.

The non-anisotropic filler has an aspect ratio of 2 or less and preferably 1.5 or less. In addition, by setting the aspect ratio to 2 or less, it is possible to prevent the viscosity of the thermally conductive composition from increasing and to achieve high filling the thermally conductive composition with the thermally conductive filler.

Specific examples of the non-anisotropic filler include a metal, a metal oxide, a metal nitride, a metal hydroxide, a carbon material, and a non-metal oxide, nitride, and carbide. In addition, examples of the shape of the non-anisotropic filler include a spherical or irregular powder.

In the non-anisotropic filler, examples of the metal include aluminum, copper, and nickel, examples of the metal oxide include aluminum oxide, magnesium oxide, and zinc oxide, and examples of the metal nitride include aluminum nitride. Examples of the metal hydroxide include aluminum hydroxide. Further, examples of the carbon material include spheroidal graphite. Examples of the non-metal oxide, nitride, and carbide include quartz, boron nitride, and silicon carbide.

Among these, aluminum oxide and aluminum nitride are preferable, and aluminum oxide is more preferable.

As the non-anisotropic filler, one of those described above may be used alone or two or more may be used in combination.

The average particle size of the non-anisotropic filler is preferably 0.1 to 100 $\mu$m and more preferably 0.3 to 90 $\mu$m. By setting the average particle size to the above lower limit value or more, the specific surface area of the non-anisotropic filler does not become larger than necessary, and the viscosity of the liquid composition is less likely to increase even when the non-anisotropic filler is blended in a large amount, to facilitate high filling with the non-anisotropic filler.

In addition, from the viewpoint of increasing the amount of the non-anisotropic filler used for filling, it is preferable to use two or more non-anisotropic fillers having different particle sizes in combination.

The average particle size of the non-anisotropic filler can be measured by observation using an electron microscope or the like. More specifically, the particle sizes of 50 arbitrary anisotropic fillers are measured using an electron microscope, an optical microscope, or an X-ray CT apparatus, and the average value (arithmetic average value) thereof can be used as the average particle size.

The anisotropic filler is a filler that has anisotropy in shape and can be oriented. The anisotropic filler is preferably at least one selected from the group consisting of a fibrous material and a flaky material. The anisotropic filler generally has a high aspect ratio and has an aspect ratio of more than 2, and one having an aspect ratio of 5 or more can also be used. In addition, the upper limit of the aspect ratio is not particularly limited, and is practically 100.

The aspect ratio is the ratio of the length in the major axis direction to the length in the minor axis direction, and in the fibrous material, the aspect ratio means fiber length/fiber diameter, and in the flaky material, the aspect ratio means the length in the major axis direction/the thickness of the flaky material.

When the anisotropic filler is a fibrous material, the average fiber length thereof is preferably 10 to 500 μm, more preferably 20 to 350 μm, and further preferably 50 to 300 μm. In addition, the average fiber length of the fibrous material is preferably shorter than the thickness of the thermally conductive sheet. Being shorter than the thickness prevents the fibrous material from protruding more than necessary from the surface of the thermally conductive sheet.

The average fiber length can be calculated by observing the anisotropic filler using a microscope. More specifically, the fiber lengths of 50 arbitrary anisotropic fillers are measured using, for example, an electron microscope or an optical microscope, and the average value (arithmetic average value) thereof can be used as the average fiber length.

In addition, when the anisotropic filler is a flaky material, the average particle size thereof is preferably 10 to 400 μm, more preferably 15 to 300 μm, and further preferably 20 to 200 μm. The average particle size of the flaky material can be calculated by observing the anisotropic filler using a microscope and using the major axis diameter as the diameter. More specifically, the major axis diameters of 50 arbitrary anisotropic fillers are measured using, for example, an electron microscope or an optical microscope, and the average value (arithmetic average value) thereof can be used as the average particle size.

As the anisotropic filler, a known material having a thermally conductive property may be used. Specific examples of the anisotropic filler include a carbon-based material typified by a carbon fiber or a flaky carbon powder, a metal material typified by a metal fiber and a metal oxide, boron nitride and a metal nitride, a metal carbide, a metal hydroxide, and a polyparaphenylene benzoxazole fiber.

One anisotropic filler may be used alone or two or more may be used in combination.

The lower limit of the content of the thermally conductive filler is preferably 50% by volume or more, more preferably 60% by volume or more, and further preferably 70% by volume or more, based on the total amount of the thermally conductive sheet. The upper limit of the content of the thermally conductive filler is preferably 90% by volume or less, more preferably 87% by volume or less, and further preferably 84% by volume or less, based on the total amount of the thermally conductive sheet.

In addition, the content of the thermally conductive filler is preferably in the range of 50 to 90% by volume, more preferably in the range of 60 to 87% by volume, and further preferably in the range of 70 to 84% by volume, based on the total amount of the thermally conductive sheet. When the content of the thermally conductive filler is equal to or more than these lower limit values, the thermal resistance value of the thermally conductive sheet decreases and the heat-dissipating property increases. When the content of the thermally conductive filler is equal to or less than these upper limit values, the fluidity of the thermally conductive composition is prevented from decreasing, it is easy to form the thermally conductive composition into a sheet, and it is easy to obtain a thermally conductive sheet having a good surface condition.

The thermally conductive sheet of the present invention includes methyl phenyl silicone and a hydrocarbon compound that is liquid at 25°C. Methyl phenyl silicone and a hydrocarbon compound that is liquid at 25°C are contained as plasticizers in the thermally conductive sheet.

<Methyl phenyl silicone>

Methyl phenyl silicone is a non-reactive silicone having a structural formula in which the silicon atom in the polysiloxane bond is partially substituted with a phenyl group instead of a methyl group as a side chain. For methyl phenyl silicone, for example, a compound having at least either a methyl phenyl siloxane unit or a diphenylsiloxane unit and a dimethylsiloxane unit may be used.

In the present invention, the thermally conductive sheet contains methyl phenyl silicone, thereby improving the peelability from an adherend such as a release sheet. In addition, even when a hydrocarbon compound that is liquid at 25°C is further contained as a plasticizer, the amount of the plasticizer component migrating to the adherend or the like can be suppressed. The principle thereof is not clear, but it is presumed as follows.

By containing a phenyl group, it is difficult for methyl phenyl silicone to be compatible with the matrix, and thus methyl phenyl silicone is easily relatively unevenly distributed on the surface of the thermally conductive sheet, and methyl phenyl silicone unevenly distributed on the surface of the thermally conductive sheet plays the role of suppressing bleeding of a further plasticizer in the thermally conductive sheet. As a result, the migration of the plasticizer including methyl phenyl silicone to the adherend can be suppressed. In addition, methyl phenyl silicone is easily relatively unevenly distributed on the surface, therefore it is possible to improve also the peelability of the thermally conductive sheet.

Further, the thermally conductive sheet can easily have good flexibility by containing methyl phenyl silicone.

In addition, methyl phenyl silicone can be added in an oil state or an oligomer state, and is preferably added in an oil state in that it can be compatible with further plasticizer and more effectively prevent a further plasticizer from migrating to the adherend or the like. In addition, the kinematic viscosity at 25°C of methyl phenyl silicone is preferably in the range of 10 to 100,000 cSt, and from the viewpoint of dispersibility in the matrix, more preferably in the range of 100 to 1000 cSt. The kinematic viscosity shall be measured according to JIS Z 8803:2011.

Among methyl phenyl silicone, it is preferable to use methyl phenyl silicone oil having a refractive index of 1.427 or more as measured according to JIS K 0062:1992. The refractive index is an index of the amount of a phenyl group in methyl phenyl silicone oil. In general, methyl phenyl silicone oil having a high refractive index reportedly has a higher content of a phenyl group than methyl phenyl silicone oil having a low refractive index. Because of this, by using methyl phenyl silicone oil having a high refractive index, migration of a further plasticizer can be more effectively suppressed even when the content of methyl phenyl silicone is relatively low. Then, the amount created by reducing the content of methyl phenyl silicone oil can be used for further filling with the thermally conductive filler, and thus it is possible to provide a thermally conductive sheet having higher thermal conductivity.

The refractive index of this methyl phenyl silicone can be measured, for example, by a method according to JIS K 0062:1992 after applying a pressure to the thermally conductive composition or a formed product obtained by curing thereof with a roller or the like and isolating the bled oil.

The lower limit of the content of methyl phenyl silicone is preferably 5 parts by volume or more, more preferably 10 parts by volume or more, and further preferably 20 parts by volume or more per 100 parts by volume of the matrix. On the other hand, the upper limit of the content of methyl phenyl silicone is preferably 100 parts by volume or less, more preferably 70 parts by volume or less, and further preferably 50 parts by volume or less per 100 parts by volume of the matrix. In addition, the methyl phenyl silicone is preferably included in an amount of 5 to 100 parts by volume, more preferably 10 to 70 parts by volume, and further preferably 20 to 50 parts by volume per 100 parts by volume of the matrix. When the content of methyl phenyl silicone is 5 parts by volume or more, bleeding of a further plasticizer such as a hydrocarbon compound can be prevented, and as a result, the amount migrating to the adherend can be suppressed. In addition, sufficient flexibility can be imparted to the thermally conductive sheet, and the thermally conductive sheet can be easily made putty-like.

In addition, by setting the content to 100 parts by volume or less, the amount of methyl phenyl silicone bled from the thermally conductive sheet can be prevented from becoming larger than necessary. In addition, reduction in the shape retainability, the mechanical strength, or the like of the thermally conductive sheet can also be prevented.

<Hydrocarbon compound>

The hydrocarbon compound used in the present invention is liquid at 25°C. In the present invention, by using a hydrocarbon compound that is liquid at 25°C, even when a thermally conductive filler is contained in a large amount, a thermally conductive sheet that is excellent in flexibility can be obtained, and the thermally conductive sheet can be easily made putty-like. Specific examples of the hydrocarbon compound that is liquid at 25°C include squalane, squalene, paraffin, pristane, and polyisobutylene.

The hydrocarbon compound used in the present invention is preferably liquid paraffin. By using liquid paraffin as the hydrocarbon compound, the flexibility of the thermally conductive sheet can be further improved.

The average molecular weight of the hydrocarbon compound is preferably 200 to 500, more preferably 225 to 350, and further preferably 250 to 300. When the average molecular weight of the hydrocarbon compound is equal to or more than the above lower limit value, the amount of the hydrocarbon compound migrating to the adherend can be easily suppressed. In addition, reduction in the mechanical strength or the like of the thermally conductive sheet can also be easily suppressed. On the other hand, when the average molecular weight of the hydrocarbon compound is equal to or less than the above upper limit value, the compatibility with a further component is excellent, making it easy to form a high-quality thermally conductive sheet. In addition, the flexibility of the thermally conductive sheet can be easily enhanced.

The density of the hydrocarbon compound is not particularly limited, and is preferably 0.80 to 0.90 g/cm$^3$, more preferably 0.82 to 0.87 g/cm$^3$, and further preferably 0.83 to 0.86 g/cm$^3$.

The kinematic viscosity at 40°C of the hydrocarbon compound is preferably 100 cSt or less, preferably 70 cSt or less, and further preferably 50 cSt or less. When the kinematic viscosity is equal to or less than the above upper limit value, the flexibility of the thermally conductive sheet can be easily enhanced, and the thermally conductive sheet can also be easily made putty-like. In addition, the hydrocarbon compound is more likely to be compatible with a further component constituting the thermally conductive sheet, making it easier to obtain a high-quality thermally conductive sheet. On the other hand, the kinematic viscosity at 40°C of the hydrocarbon compound is preferably 3 cSt or more, more preferably 5 cSt or more, and further preferably 8 cSt or more. When the kinematic viscosity of the hydrocarbon compound is equal to or more than the above lower limit value, the amount thereof migrating to the adherend can be easily suppressed, and reduction in the mechanical strength or the like of the thermally conductive sheet can also be easily suppressed. From the above viewpoints, the kinematic viscosity at 40°C of the hydrocarbon compound is preferably in the range of 3 to 100 cSt, more preferably in the range of 5 to 70 cSt, and further preferably in the range of 8 to 50 cSt.

The lower limit of the content of the hydrocarbon compound is preferably 1 part by volume or more, more preferably 5 parts by volume or more, and further preferably 10 parts by volume or more per 100 parts by volume of the matrix. On the other hand, the upper limit of the content of the hydrocarbon compound is preferably 80 parts by volume or less, more preferably 60 parts by volume or less, and further preferably 30 parts by volume or less per 100 parts by volume of the matrix. In addition, the content of the hydrocarbon compound is preferably 1 to 80 parts by volume, more preferably 5 to 60 parts by volume, and further preferably 10 to 30 parts by volume per 100 parts by volume of the matrix. When the content of the hydrocarbon compound is equal to or more than the above lower limit value, a thermally conductive sheet that is excellent in flexibility can be obtained, and the thermally conductive sheet can be easily made putty-like. On the other hand, when the content of the hydrocarbon compound is equal to or less than the above upper limit value, the amount thereof migrating to the adherend can be suppressed.

<Further plasticizer>

As the plasticizer used in the present invention, a plasticizer other than the above hydrocarbon compound and methyl phenyl silicone may be used. As such a plasticizer, it is preferable to use a non-reactive silicone oil other than methyl phenyl silicone. Examples of the silicone oil used as the further plasticizer include a straight silicone oil, and among such oils, dimethyl silicone oil is more preferable. By containing dimethyl silicone oil, the flexibility of the thermally conductive sheet can be more easily improved.

The kinematic viscosity at 25°C of dimethyl silicone oil is preferably in the range of 10 to 100,000 cSt, and from the viewpoint of dispersibility in the matrix and flexibility, more preferably in the range of 50 to 1,000 cSt.

When the thermally conductive sheet of the present invention contains dimethyl silicone oil, the lower limit of the content of dimethyl silicone oil is preferably 2 parts by volume or more, more preferably 5 parts by volume or more, and further preferably 10 parts by volume or more per 100 parts by volume of the matrix. On the other hand, the upper limit of the content of dimethyl silicone oil is preferably 100 parts by volume or less, more preferably 70 parts by volume or less, and further preferably 50 parts by volume or less per 100 parts by volume of the matrix. In addition, when the thermally conductive sheet of the present invention contains dimethyl silicone oil, the content of dimethyl silicone oil is preferably 2 to 100 parts by volume, more preferably 5 to 70 parts by volume, and further preferably 10 to 50 parts by volume per 100 parts by volume of the matrix. When the content of the dimethyl silicone oil is equal to or more than the above lower limit value, a thermally conductive sheet that is excellent in flexibility can be obtained, and the thermally conductive sheet can be easily made putty-like. On the other hand, when the content of dimethyl silicone oil is equal to or less than the above upper limit value, the amount thereof migrating to the adherend can be suppressed.

<Dispersant>

The thermally conductive sheet according to the present invention may contain a dispersant. By containing a dispersant in the thermally conductive sheet, the thermally conductive filler can be easily dispersed in the matrix even when the content of the thermally conductive filler is increased. Examples of the dispersant include a silane compound.

Examples of the silane compound include an alkoxysilane compound. The alkoxysilane compound is a compound having a structure in which 1 to 3 of the four bonds of the silicon atom (Si) are bonded to alkoxy groups and the remaining bond(s) is(are) bonded to an organic substituent. Examples of the alkoxy group of the alkoxysilane compound include a methoxy group, an ethoxy group, a propoxy group, a butoxy group, a pentoxy group, and a hexoxy group. The alkoxysilane compound may be contained as a dimer.

Among the alkoxysilane compounds, an alkoxysilane compound having a methoxy group or an ethoxy group is preferable from the viewpoint of easy availability. The number of alkoxy groups of the alkoxysilane compound is preferably 3 from the viewpoint of enhancing the affinity for the thermally conductive filler as an inorganic substance. The alkoxysilane compound is more preferably at least one selected from the group consisting of a trimethoxysilane compound and a triethoxysilane compound.

Examples of a functional group included in the organic substituent of the alkoxysilane compound include an acryloyl group, an alkyl group, a carboxyl group, a vinyl group, a methacryloyle group, an aromatic group, an amino group, an isocyanate group, an isocyanurate group, an epoxy group, a hydroxyl group, and a mercapto group.

Here, when an addition-reaction type organopolysiloxane is used as a precursor of the above matrix and a platinum catalyst is used as a curing catalyst, it is preferable to select and use an alkoxysilane compound that is unlikely to affect the curing reaction of the organopolysiloxane forming the matrix. Specifically, the organic substituent of the alkoxysilane compound preferably does not include an amino group, an isocyanate group, an isocyanurate group, a hydroxyl group, or a mercapto group.

The alkoxysilane compound facilitates high filling with the thermally conductive filler by enhancing the dispersibility of the thermally conductive filler, and thus it is preferable to include an alkylalkoxysilane compound having an alkyl group bonded to a silicon atom, that is, an alkoxysilane compound having an alkyl group as an organic substituent. The number of carbon atoms of the alkyl group bonded to the silicon atom is preferably 4 or more. In addition, the number of carbon atoms of the alkyl group bonded to the silicon atom is preferably 16 or less from the viewpoint of causing the viscosity of the alkoxysilane compound itself to be relatively low and suppressing the viscosity of the thermally conductive composition to a low level.

As the alkoxysilane compound, one or two or more can be used. Specific examples of the alkoxysilane compound include an alkyl group-containing alkoxysilane compound, a vinyl group-containing alkoxysilane compound, an acryloyl group-containing alkoxysilane compound, a methacryloyle group-containing alkoxysilane compound, an aromatic group-containing alkoxysilane compound, an amino group-containing alkoxysilane compound, an isocyanate group-containing alkoxysilane compound, an isocyanurate group-containing alkoxysilane compound, an epoxy group-containing alkoxysilane compound, and a mercapto group-containing alkoxysilane compound. Among these, an alkyl group-containing alkoxysilane compound is preferable.

Examples of the alkyl group-containing alkoxysilane compound include methyltrimethoxysilane, dimethyldimethoxysilane, trimethylmethoxysilane, methyltriethoxysilane, dimethyldiethoxysilane, ethyltrimethoxysilane, n-propyltrimethoxysilane, n-propyltriethoxysilane, isobutyltrimethoxysilane, isobutyltriethoxysilane, n-hexyltrimethoxysilane, n-hexyltriethoxysilane, cyclohexylmethyldimethoxysilane, n-octyltriethoxysilane, and n-decyltrimethoxysilane. Among the alkyl group-containing alkoxysilane compounds, at least one selected from the group consisting of isobutyltrimethoxysilane, isobutyltriethoxysilane, n-hexyltrimethoxysilane, n-hexyltriethoxysilane, cyclohexylmethyldimethoxysilane, n-octyltriethoxysilane, and n-decyltrimethoxysilane is preferable, at least one selected from the group consisting of n-octyltriethoxysilane and n-decyltrimethoxysilane is more preferable, and n-decyltrimethoxysilane is particularly preferable.

The dispersant may be a volatile compound. As used herein, the volatile compound means a compound having at least either one of the following properties: the temperature T1 at which the weight loss when the temperature is raised under a condition of 2°C/min in thermogravimetric analysis is 90% is in the range of 70 to 300°C, and the boiling point (1 atm) is in the range of 60 to 200°C. Here, the temperature T1 at which the weight loss is 90% means the temperature at which when the weight of a sample before thermogravimetric analysis is 100%, the weight is reduced by 90% (that is, the temperature at which the weight is 10% of the weight before measurement). When the dispersant is a volatile compound, a volatile silane compound among the above silane compounds may be used as the dispersant.

As will be described later, the dispersant may be blended into the thermally conductive composition before cured, but when the dispersant is a volatile compound, part or all of the dispersant may be volatilized by the heating during curing the thermally conductive composition. Therefore, even when a dispersant is blended into the thermally conductive composition before cured, the dispersant may not be contained in the thermally conductive sheet after curing the thermally conductive composition.

<Additive>

The thermally conductive sheet may optionally contain an additive other than the above. Examples of the additive include at least one or more selected from the group consisting of a pressure-sensitive adhesive, a flame retardant, an antioxidant, a colorant, an antisettling agent, and the like. In addition, for example, when a curable silicone composition is used as described above, a curing catalyst or the like that accelerates the curing may be blended. Examples of the curing catalyst include a platinum-based catalyst.

<Static load Fs and dynamic load Fd>

The thermally conductive sheet of the present invention is preferably putty-like. The putty-like thermally conductive sheet has high flexibility, and thus can be moderately compressed and disposed inside an electronic device. Because of this, the putty-like thermally conductive sheet can be closely contacted with an electronic component, a heat-dissipating element, or the like inside an electronic device, and can enhance the heat-dissipating property.

It can be deemed that being putty-like is, for example, the property of retaining the shape without deforming under the own weight and being unable or being unlikely to return to the original shape when deformed by a load or the like. Such a property can be expressed by a "static load Fs" and a "dynamic load Fd."

The "dynamic load Fd" is the load at the time of pressing at a predetermined speed that is not slow, and is an index that indicates the hardness (that is, the magnitude of stress against deformation) of a sheet (cured material). In addition, the "dynamic load Fd" is also related to shape retainability in which the sheet shape is maintained.

On the other hand, the "static load Fs" is the load when a predetermined time has passed after pressing to a predetermined depth, and is an index of the magnitude of the repulsive force from a deformed state (that is, the force to return to the original shape).

Based on the above points, when being putty-like is expressed by Fd and Fs, Fd has a relatively moderately large value and Fs has a relatively small value.

The thermally conductive sheet of the present invention preferably has a ratio Fs/Fd, expressed by the static load Fs and the dynamic load Fd, of less than 0.35. When Fs/Fd is less than 0.35, good flexibility can be imparted to the thermally conductive sheet, and the thermally conductive sheet can be made putty-like. From this viewpoint, Fs/Fd is more preferably 0.30 or less, further preferably 0.25 or less, and more further preferably 0.20 or less. On the other hand, the lower limit of Fs/Fd is not particularly limited, but is preferably 0.05 or more, and more preferably 0.10 or more, from the viewpoint of the shape retainability and the handleability of the thermally conductive sheet. In addition, from the above viewpoint, Fs/Fd is preferably 0.05 or more and less than 0.35, more preferably 0.05 to 0.3, further preferably 0.10 to 0.25, and more further preferably 0.10 to 0.20. In addition, the dynamic load Fd may be equal to or less than a certain value, and is preferably 100 N or less, more preferably 50 N or less, and further preferably 30 N or less. In addition, the lower limit of the dynamic load Fd is not particularly limited, and is, for example, 5 N or more. In addition, the range of the dynamic load Fd is preferably 5 to 100 N, more preferably 5 to 50 N, and further preferably 5 to 30 N.

In addition, Fs and Fd can each be measured by the method described in the Examples.

Fs/Fd can be set within the above range by adjusting the blending ratio of each component of the thermally conductive sheet and the crosslink density of the matrix. For example, Fs/Fd tends to decrease when increasing the blending ratio of methyl phenyl silicone, the hydrocarbon compound, and a plasticizer other than these. In addition, Fs/Fd tends to decrease even when reducing the crosslink density of the matrix.

<40% Compressive load and 8 psi compressibility>

The lower limit of the 40% compressive load of the thermally conductive sheet of the present invention is preferably 1 N or more, more preferably 2 N or more, and further preferably 3 N or more. On the other hand, the upper limit of the 40% compressive load of the thermally conductive sheet of the present invention is preferably 25 N or less, more preferably 20 N or less, and further preferably 15 N or less. In addition, the 40% compressive load of the thermally conductive sheet of the present invention is preferably 1 to 25 N, more preferably 2 to 20 N, and further preferably 3 to 15 N. In addition, in the thermally conductive sheet of the present invention, the lower limit of the compressibility when the sheet is compressed with a force of 8 psi (hereinafter referred to as "8 psi compressibility") is preferably 20% or more, more preferably 25%, and further preferably 30% or more. In addition, in the thermally conductive sheet of the present invention, the upper limit of the compressibility when the sheet is compressed with a force of 8 psi is preferably 70% or less, more preferably 65% or less, and further preferably 60% or less. In addition, in the thermally conductive sheet of the present invention, the compressibility when the sheet is compressed with a force of 8 psi is preferably 20 to 70%, more preferably 25 to 65%, and further preferably 30 to 60%.

When the 40% compressive load and the 8 psi compressibility are equal to or more than their respective lower limit values, a thermally conductive sheet that is excellent in shape retainability and handleability can be obtained. In addition, when the 40% compressive load and the 8 psi compressibility are equal to or less than their respective upper limit values, the thermally conductive sheet is excellent in flexibility.

The 40% compressive load and the 8 psi compressibility can each be measured by the method described in the Examples.

<Thermal resistance value>

The thermal resistance value of the thermally conductive sheet of the present invention is preferably 2.00°C/W or less, more preferably 1.50°C/W or less, and further preferably 1.20°C/W or less. When the thermal resistance value is such a value, the thermally conductive sheet easily transfers heat from a heating element to a heat-dissipating element. The smaller the thermal resistance value, the better, and the thermal resistance value may be, for example, 0.1°C/W or more. The above thermal resistance value is the thermal resistance value in the thickness direction measured in a state in which the thermally conductive sheet is compressed by 30%, and is specifically measured by the method described in the Examples.

The thickness of the thermally conductive sheet is not particularly limited, and may be appropriately set according to the shape and application of the electronic device on which the thermally conductive sheet is mounted, and may be in the range of, for example, 0.1 to 5 mm.

In addition, the thermally conductive sheet may form a thermally conductive sheet laminated body including a thermally conductive sheet and a release sheet attached to at least one side of the thermally conductive sheet by attaching the release sheet to one or both sides of the thermally conductive sheet. The release sheet protects the thermally conductive sheet before use of the thermally conductive sheet, and may be peeled off from the thermally conductive sheet when the thermally conductive sheet is used. As described above, the thermally conductive sheet is excellent in peelability, and thus it is possible to prevent part of the thermally conductive sheet from remaining on the release sheet when the thermally conductive sheet is peeled off from the release sheet. The release sheet may be a resin sheet, or a resin sheet having at least one side subjected to a release treatment. As the resin sheet, the resin sheet used to produce the thermally conductive sheet may be used as it is, as described in the production method described later.

[Method for producing thermally conductive sheet]

The method for producing the thermally conductive sheet of the present invention is not particularly limited, and the thermally conductive sheet can be produced, for example, by a production method including the following steps X and Y.

Step X: A step of mixing at least a matrix precursor for obtaining a matrix, a thermally conductive filler, methyl phenyl silicone, and a hydrocarbon compound to obtain a thermally conductive composition
Step Y: A step of curing the thermally conductive composition obtained in step X by heating

Hereinafter, each step will be described in detail.

<Step X>

In step X, at least a matrix precursor, a thermally conductive filler, methyl phenyl silicone, and a hydrocarbon compound that is liquid at 25°C are mixed to obtain a thermally conductive composition. The matrix precursor consists of the component(s) before cured for constituting the matrix, and the above curable silicone composition or the like may be used. Into the thermally conductive composition, a plasticizer other than methyl phenyl silicone and the hydrocarbon compound, a dispersant, an additive, or the like may optionally be appropriately further mixed. For mixing each component constituting the thermally conductive composition, for example, a known kneader, kneading roll, mixer, or vibration stirrer may be used.
In step X, the thermally conductive composition preferably has fluidity from the viewpoint of being able to uniformly mix each component. In addition, when the dispersant blended in the thermally conductive composition is a volatile compound, at least part thereof may be volatilized by the heating in step Y. In the thermally conductive composition before curing, the dispersant may be blended in an amount of, for example, 1 to 30 parts by volume, preferably 5 to 20 parts by volume, per 100 parts by volume of the matrix precursor.

<Step Y>

Step Y is a step of curing the thermally conductive composition by heating. The temperature at which the thermally conductive composition is heated is not particularly limited as long as a matrix precursor such as a curable silicone composition can be cured by heating, and may be higher than room temperature (23°C), and the thermally conductive composition may preferably be heated at a temperature of 50°C or more. In addition, the heating temperature is not particularly limited, and may be a temperature at which the thermally conductive composition is not thermally degraded, and is, for example, 180°C or less, and preferably 150°C or less. In addition, the heating of the thermally conductive composition may be carried out in one stage or in two or more stages. When the heating is carried out in two or more stages, the heating temperature may be within the above range in at least one of the stages, and the heating temperature is preferably within the above range in all stages. In addition, the total heating time is, for example, about 10 minutes to 3 hours. In addition, when the heating is carried out in two or more stages, for example, the thermally conductive composition may be semi-cured in the first stage, and the thermally conductive composition may be fully cured by heating in the second and subsequent stages.
In addition, when the thermally conductive composition contains a dispersant that is a volatile compound, in step Y, at least part of the dispersant may be volatilized by the heating. By dispersing the thermally conductive filler in the composition before curing, the dispersed state thereof can be maintained even in the thermally conductive sheet even when the dispersant is volatilized in step Y.
In step Y, the thermally conductive composition may be formed into a predetermined shape such as a block or a sheet, and then cured as described above and by heating. In addition, in step Y, when the thermally conductive composition contains an anisotropic filler as the thermally conductive filler, the anisotropic filler may be oriented in one direction and then cured by heating. The anisotropic filler may be oriented by a magnetic field orientation method, a flow orientation method, or the like.
In step Y, the thermally conductive composition obtained in step X may be preferably injected into a mold and formed into a predetermined shape such as a block or a sheet. In addition, the thermally conductive composition may be sandwiched between two resin sheets and pressurized to form the same into a sheet.
The method for sandwiching the thermally conductive composition between two resin sheets is not particularly limited, and examples thereof include a method involving applying the thermally conductive composition onto the surface of one of the two resin sheets and overlaying the other resin sheet on the application side. The means for pressurization is not particularly limited, and the pressurization may be carried out using, for example, a roll or a press.
The two resin sheets are not particularly limited, and may be low gas-permeable films or gas-permeable films.

For example, one of the two resin films may be a gas-permeable film, or the both may be gas-permeable films. By using a gas-permeable film, when a dispersant that is a volatile compound is blended into the thermally conductive composition, the dispersant can be easily volatilized from the thermally conductive composition during the heating in step Y.

Here, the gas permeability means the property of a liquid being unable to permeate but a gas being able to permeate, and the oxygen permeability of the gas-permeable film is, for example, $5 \times 10^3$ cm³/(m²•day•MPa) or more. On the other hand, the oxygen permeability of the low gas-permeable film is less than $5.0 \times 10^3$ cm³/m²•day•MPa. Here, the oxygen permeability is measured according to JIS K7126-2.

Examples of the gas-permeable film include a porous film and a non-porous gas-permeable film. The porous film is a film having a plurality of pores, and is formed from a mixture of a polymer and a filler, a mixture of polymers, or the like. The non-porous gas-permeable film is a film that has no pores as formed in a porous film and has gas permeability. Among these, the non-porous gas-permeable film is preferable as the gas-permeable film.

The polymer constituting the gas-permeable film is not particularly limited, and examples thereof include low-density polyethylene, linear low-density polyethylene, polymethylpentene, ethyl cellulose, and a fluorine-based resin such as polytetrafluoroethylene or a fluorine-modified resin. Among these, a non-porous gas-permeable film formed from polymethylpentene is preferable. The gas-permeable film formed from polymethylpentene has high gas permeability while it has a moderate thickness, and thus when the matrix is cured, the volatile compound can be suitably volatilized, and further, when the gas-permeable film is peeled off from the sheet, the gas-permeable film is excellent in peelability. When a non-porous gas-permeable film formed from polymethylpentene is used, the matrix precursor does not penetrate into a pore when the thermally conductive composition is applied, and thus the peelability is particularly excellent, and further, unevenness due to a pore is not formed because of the absence of a pore on the film surface, and a primary sheet having little unevenness and a good surface condition can be obtained.

The gas-permeable film may be a gas-permeable film using the polymer alone, or may be used as a multilayer gas-permeable film obtained by laminating a plurality of resin layers formed from polymers having different gas-permeabilities. In this case, even when a resin other than the above polymer is used, by forming a thin resin layer, a multilayer gas-permeable film having an oxygen permeability of $5.0 \times 10^3$ cm³/m²•day•MPa or more as a whole may be configured.

When the thermally conductive sheet is used, the resin sheet on the surface is peeled off and used, and thus the resin sheet is preferably a release film made of a resin having good peelability or a release film having a release layer on at least one surface thereof.

The thickness of the resin film is not particularly limited, and is, for example, 5 to 300 μm, preferably 10 to 250 μm, and more preferably 30 to 200 μm. The thickness may be appropriately adjusted in such a way as to provide the desired oxygen permeability.

When the thermally conductive filler includes an anisotropic filler, the anisotropic filler may be oriented by a magnetic field orientation method or a flow orientation method.

In the magnetic field orientation method, the thermally conductive composition may be injected into a mold or the like and then placed in a magnetic field to orient the anisotropic filler along the magnetic field. Then, an oriented formed product may be obtained by curing a matrix precursor such as a curable silicone composition. The curing of the thermally conductive composition may be carried out under the heating conditions as described above.

The oriented formed product is preferably block-shaped, and may be sheet-shaped. When the oriented formed product is sheet-shaped, the oriented formed product can be used as a thermally conductive sheet as it is without being sliced. On the other hand, when the oriented formed product is block-shaped, the orientation of the anisotropic filler can be enhanced.

In the flow orientation method, a shear force is applied to the thermally conductive composition to produce a primary sheet in which the anisotropic filler is oriented along the plane direction. More specifically, in the flow orientation method, first, the thermally conductive composition prepared in step X is stretched flat while a shear force is applied thereto, to form the same into a sheet (primary sheet). By applying a shear force, the anisotropic filler can be oriented in the shear direction. As means for forming a sheet, for example, the thermally conductive composition may be applied onto a resin film using a coating applicator such as a bar coater or a doctor blade, or by extrusion, discharge from a nozzle, or the like, and then optionally dried, or the thermally conductive composition may be semi-cured or fully cured. The thickness of the primary sheet is preferably about 50 to 5000 μm. In the primary sheet, the anisotropic filler is oriented in one direction along the plane direction of the sheet.

The primary sheet may be used as a thermally conductive sheet by curing the thermally conductive composition as it is without forming a block as described later. In addition, a plurality of primary sheets may be overlaid and laminated such that the orientation direction is the same, then adhered to each other by hot pressing or the like while being optionally cured by heating, to form a laminated block (block-shaped oriented formed product).

In addition, when forming a laminated block, the primary sheets may be overlaid after irradiating at least one of the mutually overlaid sides of the primary sheets with vacuum ultraviolet radiation. When the primary sheets are overlaid via the side irradiated with vacuum ultraviolet radiation, the primary sheets can be firmly adhered to each other. In addition, in the case of irradiating the primary sheet with vacuum ultraviolet radiation, a primary sheet may be fully cured before being overlaid on another primary sheet, and when the primary sheets are overlaid to form a laminated block, the primary sheets do not need to be cured by heating or the like.

As described above, when forming a block-shaped oriented formed product, the obtained oriented formed product may be cut by slicing or the like perpendicularly to the direction in which the anisotropic filler is oriented. The slicing may be carried out, for example, with a shear blade. The sheet-shaped formed product obtained by cutting may be used as a thermally conductive sheet as it is, or may be further subjected to another treatment. For example, each surface that is a cut surface may be polished. The polishing of the surface may be carried out using, for example, abrasive paper.

[Application of thermally conductive sheet]

The thermally conductive sheet is used inside an electronic device or the like. Specifically, the thermally conductive sheet is interposed between a heating element and a heat-dissipating element, conducts heat generated by the heating element, and transfers the heat to the heat-dissipating element to dissipate the heat from the heat-dissipating element. Here, examples of the heating element include various electronic parts such as a CPU, a power amplifier, and a power supply such as a battery used inside an electronic device. In addition, examples of the heat-dissipating element include a heat sink, a heat pipe, a heat pump, and a metal housing of an electronic device. The thermally conductive sheet is used by causing both surfaces to be in close contact with the heating element and the heat-dissipating element, respectively, and being compressed.

[Thermally conductive composition]

The present invention further provides a thermally conductive composition. As described above, the thermally conductive composition is cured to form a thermally conductive sheet. The thermally conductive composition includes an alkenyl group-containing organopolysiloxane, a hydrogen organopolysiloxane, a thermally conductive filler, methyl phenyl silicone, and a hydrocarbon compound that is liquid at 25°C. The hydrocarbon compound included in the thermally conductive composition is preferably liquid paraffin.

In addition, the thermally conductive composition may contain a plasticizer other than methyl phenyl silicone. The plasticizer other than methyl phenyl silicone included in the thermally conductive composition is preferably dimethyl silicone oil.

The thermally conductive composition may further contain a dispersant and an additive.

Details of the alkenyl group-containing organopolysiloxane, the hydrogen organopolysiloxane, the thermally conductive filler, and methyl phenyl silicone, the hydrocarbon compound that is liquid at 25°C, the plasticizer other than methyl phenyl silicone, the dispersant, and the additive are as described above, and the content thereof is also as described above, and thus detailed description thereof will be omitted.

However, in the above description, the content of each component is partly based on the total amount of the thermally conductive sheet, but the thermally conductive sheet is formed from a thermally conductive composition, and thus in the thermally conductive composition, the content based on the total amount of the thermally conductive sheet described above can be regarded as the content based on the total amount of the thermally conductive composition.

In addition, the content of each component is partly per 100 parts by volume of the matrix, but as described above, the matrix is formed from a matrix precursor such as a curable silicone composition, and in the thermally conductive composition, the component means a component before cured (for example, curable silicone resin) for constituting the matrix, contained in the thermally conductive composition. Therefore, in the thermally conductive composition, the content per 100 parts by volume of the matrix described above can be regarded as the content per 100 parts by volume of the matrix precursor. The matrix precursor is typically a curable silicone composition, and more specifically is composed of an alkenyl group-containing organopolysiloxane and a hydrogen organopolysiloxane.

Examples

Hereinafter, the present invention will be described in more detail with reference to Examples, but the present invention is not limited to these Examples at all.

[Measurements and evaluations]

In the present Examples, measurements and evaluations were carried out by the following methods.

<Peelability>

The polymethylpentene film was peeled off from the thermally conductive sheet obtained in each of the Examples and the Comparative Examples.

When the polymethylpentene film was peeled off, almost no residue of the thermally conductive sheet remained on the surface of the polymethylpentene film, and the surface of the thermally conductive sheet remained clean even after peeling, a rating of "A" was given, and when much residue remained and the surface of the thermally conductive sheet was left in a rough state, a rating of "B" was given.

<Residual amount>

After the peeling, the weight of the residue of the thermally conductive sheet migrating to the polymethylpentene film per area of 10 mm × 10 mm (hereinafter sometimes referred to as the "residual amount") was measured. Specifically, the residual amount was calculated by subtracting the weight of the 10 mm × 10 mm polymethylpentene film before use from the weight of the 10 mm × 10 mm polymethylpentene film after peeled off from the thermally conductive sheet.

<40% Compressive load>

A test piece having a size of 12 mm × 12 mm and a thickness of 2 mm was created, and then the thermally conductive sheet was compressed using a load cell by 40% of the original thickness of the thermally conductive sheet, and the load when this state was maintained for 8 minutes was measured.

<8 psi Compressibility (%)>

A test piece having a size of 12 mm × 12 mm and a thickness of 2 mm was created, and then the compressibility of the thermally conductive sheet was calculated when the thermally conductive sheet was compressed with a compressive stress of 8 psi using a load cell. The compressibility was calculated by the following expression. The 40% compressive load and the 8 psi compressibility were measured in a 25°C environment. Compressibility (%) = (thickness when compressed (mm)/original thickness (mm)) × 100

<Fs and Fd>

A test piece having a size of 15 mm × 15 mm and a thickness of 2 mm was created, and then Fs and Fd were measured using a load cell according to the following procedures (1) and (2). The thickness of the test piece was the same as the thickness of the thermally conductive sheet.

(1) 30% Compression (compression to a thickness that was 70% of the original thickness) was carried out at a speed of 1 mm/min in a 25°C environment. The maximum stress during this compression was measured, and this maximum stress was defined as the dynamic load Fd.
(2) The state of 30% compression was maintained for 5 minutes in a 25°C environment, the load after the maintenance was measured, and the resulting load was defined as the static load Fs.

<Thermal resistance value>

The thermal resistance value was measured using a thermal resistance measuring instrument as shown in Fig. 1 by the method shown below.

Specifically, for each sample, a test piece S having a size of 12 mm × 12 mm was created for the present test. Then, each test piece S was attached onto a copper block 22 having a measurement surface of 12 mm × 12 mm and having a side surface covered with a thermal insulator 21, and sandwiched between the copper block 22 and an upper copper block 23, and a load was applied using a load cell 26 such that the thickness was 1.4 mm (70% of the original thickness). Here, the lower copper block 22 is in contact with a heater 24. In addition, the upper copper block 23 is covered with the thermal insulator 21 and connected to a heat sink 25 with a fan. Next, the heater 24 was caused to generate heat at an amount of heat generated of 25 W, and 10 minutes after the temperature became in a substantially steady state, the temperature of the upper copper block 23 ($\theta_{j0}$), the temperature of the lower copper block 22 ($\theta_{j1}$), and the amount of heat generated of the heater (Q) were measured, and the thermal resistance value of each sample was determined from the following expression (1).

$$\text{Thermal resistance} = (\theta_{j1} - \theta_{j0})/Q \quad \text{... Expression (1)}$$

In the expression (1), $\theta_{j1}$ is the temperature of the lower copper block 22, $\theta_{j0}$ is the temperature of the upper copper block 23, and Q is the amount of heat generated.

[Components used in thermally conductive sheet]

The following components were used to produce thermally conductive sheets.

<Matrix>

- Alkenyl group-containing organopolysiloxane
- Hydrogen organopolysiloxane

<Plasticizer>

- Dimethyl silicone: kinematic viscosity at 25°C of 110 cSt
- Methyl phenyl silicone: kinematic viscosity at 25°C of 125 cSt, refractive index of 1.49, specific gravity of 1.065
- Liquid paraffin: average molecular weight of 400, density of 0.852 g/cm$^3$, kinematic viscosity at 40°C of 37 cSt

<Dispersant>

- n-Decyltrimethoxysilane: The temperature T1 at which the weight loss when the temperature is raised under a condition of 2°C/min in thermogravimetric analysis is 90% is 187°C

<Thermally conductive filler>

- Aluminum oxide 1 •• average particle size of 0.5 μm
- Aluminum oxide 2 •• average particle size of 3 μm
- Aluminum oxide 3 •• average particle size of 40 μm
- Aluminum oxide 4 •• average particle size of 70 μm

[Example 1]

A thermally conductive composition created according to the blending in Table 1 was sandwiched between two polymethylpentene films and stretched using a spacer such that the thickness of the thermally conductive composition was 2 mm, and then the composition was cured by heating at 80°C for 12 hours to obtain a thermally conductive sheet.

[Examples 2 to 5 and Comparative Examples 1 to 3]

Thermally conductive sheets having a thickness of 2 mm were obtained in the same manner as in Example 1 except that the blending of the thermally conductive composition was changed as shown in Table 1.

[Table 1]

| | | | Example 1 | Example 2 | Example 3 | Example 4 | Example 5 | Comparative Example 1 | Comparative Example 2 | Comparative Example 3 |
|---|---|---|---|---|---|---|---|---|---|---|
| Blending (parts by volume) | Matrix | Alkenyl group-containing organopolysiloxane | 49.4 | 49.4 | 49.4 | 49.4 | 49.4 | 49.4 | 49.4 | 49.1 |
| | | Hydrogen organopolysiloxane | 50.6 | 50.6 | 50.6 | 50.6 | 50.6 | 50.6 | 50.6 | 50.9 |
| | Plasticizer | Dimethyl silicone | 41.4 | 35.6 | 28.7 | 24.1 | | 60.9 | 52.9 | 31.3 |
| | | Methyl phenyl silicone | 32.2 | 32.2 | 32.2 | 32.2 | 60.9 | | 32.2 | 35.0 |
| | | Liquid paraffin | 11.5 | 17.2 | 24.1 | 28.7 | 24.1 | 24.1 | | 16.3 |
| | Dispersant | n-Decyltrimethoxysilane | 14.9 | 14.9 | 14.9 | 14.9 | 14.9 | 14.9 | 14.9 | 16.3 |
| | Thermally conductive filler | Aluminum oxide (spherical, 0.5 μm) | 80.5 | 80.5 | 80.5 | 80.5 | 80.5 | 80.5 | 80.5 | 64.8 |
| | | Aluminum oxide (spherical, 3 μm) | 294.3 | 294.3 | 294.3 | 294.3 | 294.3 | 294.3 | 294.3 | 237.0 |
| | | Aluminum oxide (spherical, 40 μm) | 229.9 | 229.9 | 229.9 | 229.9 | 229.9 | 229.9 | 229.9 | 185.2 |
| | | Aluminum oxide (spherical, 70 μm) | 344.8 | 344.8 | 344.8 | 344.8 | 344.8 | 344.8 | 344.8 | 277.8 |
| Physical properties and the like | | Residual amount (mg) | 0.12 | 0.09 | 0.07 | 0.06 | 0.04 | 1.3 | - | 0.07 |
| | | Evaluation of peelability | A | A | A | A | A | B | - | A |
| | | 40% Compressive load (N) | 4.0 | 10.5 | 13.5 | 7.5 | 15.5 | 14.0 | - | 58.0 |
| | | 8 psi Compressibility (%) | 56.0 | 34.5 | 31.0 | 42.0 | 29.8 | 30.5 | - | 5.2 |
| | | Dynamic load Fd (N) | 14.6 | 27.2 | 25.2 | 24.1 | 20.2 | 11.1 | - | 140.9 |
| | | Static load Fs (N) | 2.5 | 5.4 | 4.6 | 3.4 | 5.0 | 1.5 | - | 37.0 |
| | | Fs/Fd | 0.17 | 0.20 | 0.18 | 0.14 | 0.25 | 0.14 | - | 0.26 |
| | | 1.4 mm Thermal resistance value (°C/W) | 1.02 | 1.01 | 1.01 | 1.00 | 1.00 | 0.98 | - | 1.02 |

As is clear from the above results of the Examples, the thermally conductive sheets satisfying the requirements of the present invention had high thermal conductivity and good flexibility, were excellent in peelability, and were able to suppress the amount thereof migrating to the adherend.

On the other hand, the thermally conductive sheet created in Comparative Example 1 contained a hydrocarbon compound that was liquid at 25°C but did not contain methyl phenyl silicone, and thus had insufficient flexibility, had insufficient peelability, and were unable to suppress the amount thereof migrating to the adherend. In addition, in Comparative Example 2, the thermally conductive composition was powdery, and no thermally conductive sheet was able to be created. Further, in Comparative Example 3, the thermally conductive sheet did not contain a hydrocarbon compound that was liquid at 25°C, and thus had insufficient flexibility and was unable to be made even putty-like.

For Example 4 and Comparative Example 1, migrants were analyzed by infrared spectroscopy. Infrared spectroscopy was carried out by the ATR method (diamond prism) using Nicolet iS5 (manufactured by Thermo Fisher Scientific Inc.).

The mass ratio of dimethyl silicone:methyl phenyl silicone:liquid paraffin was estimated from comparison of the absorbance with the reference for the infrared absorption spectrum, and then was found to be 6:76:18 for Example 4 and 88:0:12 for Comparative Example 1.

In Example 4, the blending ratio was 28:37:34, and thus the proportion of methyl phenyl silicone in the migrant was large. The amount migrating was 0.06 mg, and thus it can be presumed that methyl phenyl silicone reduces the migration and suppresses the migration of dimethyl silicone and liquid paraffin. That is, it can be presumed that methyl phenyl silicone was relatively unevenly distributed on the surface to suppress bleeding and migration of a further plasticizer, whereas migration of methyl phenyl silicone itself was suppressed, and as a result, the amount migrating to the release sheet was able to be suppressed. In addition, it can be presumed that the uneven distribution of methyl phenyl silicone on the surface also improves the peelability.

On the other hand, in Comparative Example 1, the blending ratio was 72:0:28, and thus the migration proportion of dimethyl silicone was large. In addition, the amount migrating was 1.3 mg, which was overwhelmingly larger than in Example 4, and the migration of dimethyl silicone and liquid paraffin was unable to be sufficiently suppressed.

Reference Signs List

21 Thermal insulator

22 Lower copper block
23 Upper copper block
24 Heater
25 Heat sink
26 Load cell
S Test piece
$\theta_{j0}$ Temperature of upper copper block
$\theta_{j1}$ Temperature of lower copper block

**Claims**

1. A thermally conductive sheet comprising: a matrix formed of an organopolysiloxane; a thermally conductive filler included in the matrix; methyl phenyl silicone; and a hydrocarbon compound that is liquid at 25°C.

2. The thermally conductive sheet according to claim 1, wherein Fs/Fd, which is a ratio of a static load Fs to a dynamic load Fd, is less than 0.35.

3. The thermally conductive sheet according to claim 1 or 2, wherein the hydrocarbon compound is liquid paraffin.

4. The thermally conductive sheet according to any one of claims 1 to 3, wherein the methyl phenyl silicone is 5 to 100 parts by volume per 100 parts by volume of the matrix.

5. The thermally conductive sheet according to any one of claims 1 to 4, wherein a content of the hydrocarbon compound is 1 to 80 parts by volume per 100 parts by volume of the matrix.

6. The thermally conductive sheet according to any one of claims 1 to 5, further comprising dimethyl silicone oil.

7. The thermally conductive sheet according to claim 6, wherein the dimethyl silicone oil is 2 to 100 parts by volume per 100 parts by volume of the matrix.

8. A thermally conductive composition comprising an alkenyl group-containing organopolysiloxane, a hydrogen organopolysiloxane, a thermally conductive filler, methyl phenyl silicone, and a hydrocarbon compound that is liquid at 25°C.

9. The thermally conductive composition according to claim 8, wherein the hydrocarbon compound is liquid paraffin.

10. The thermally conductive composition according to claim 8 or 9, further comprising dimethyl silicone oil.

11. A thermally conductive sheet laminated body comprising the thermally conductive sheet according to any one of claim 1 to 7 and a release sheet attached to at least one side of the thermally conductive sheet.

12. An electronic device comprising the thermally conductive sheet according to any one of claim 1 to 7 interposed between a heating element and a heat-dissipating element.

Fig. 1

## INTERNATIONAL SEARCH REPORT

| International application No. |
| --- |
| **PCT/JP2022/036313** |

| **A.** | **CLASSIFICATION OF SUBJECT MATTER** |
| --- | --- |

*H01L 23/373*(2006.01)i; *C08K 5/01*(2006.01)i; *C08L 83/04*(2006.01)i; *C09K 5/14*(2006.01)i; *C08K 3/013*(2018.01)i
FI: H01L23/36 M; C08L83/04; C08K5/01; C08K3/013; C09K5/14 102E

According to International Patent Classification (IPC) or to both national classification and IPC

| **B.** | **FIELDS SEARCHED** |
| --- | --- |

Minimum documentation searched (classification system followed by classification symbols)

H01L23/373; C08K5/01; C08L83/04; C09K5/14; C08K3/013

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| **C.** | **DOCUMENTS CONSIDERED TO BE RELEVANT** |
| --- | --- |

| Category* | Citation of document, with indication, where appropriate, of the relevant passages | Relevant to claim No. |
| --- | --- | --- |
| A | JP 2020-007569 A (SEKISUI POLYMATECH CO., LTD.) 16 January 2020 (2020-01-16) entire text, all drawings | 1-12 |
| A | JP 2018-065977 A (SEKISUI POLYMATECH CO., LTD.) 26 April 2018 (2018-04-26) entire text, all drawings | 1-12 |
| A | JP 2021-090066 A (SEKISUI POLYMATECH CO., LTD.) 10 June 2021 (2021-06-10) entire text, all drawings | 1-12 |
| A | JP 2002-129019 A (SHIN-ETSU CHEMICAL CO., LTD.) 09 May 2002 (2002-05-09) entire text, all drawings | 1-12 |
| A | JP 2021-086887 A (SEKISUI POLYMATECH CO., LTD.) 03 June 2021 (2021-06-03) entire text, all drawings | 1-12 |
| A | JP 2020-128463 A (SHIN-ETSU CHEMICAL CO., LTD.) 27 August 2020 (2020-08-27) entire text, all drawings | 1-12 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **31 October 2022** | **15 November 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2022/036313**

| Patent document cited in search report | | | Publication date (day/month/year) | Patent family member(s) | | | Publication date (day/month/year) |
|---|---|---|---|---|---|---|---|
| JP | 2020-007569 | A | 16 January 2020 | US 2020/0385577 entire text, all drawings | | A1 | |
| JP | 2018-065977 | A | 26 April 2018 | (Family: none) | | | |
| JP | 2021-090066 | A | 10 June 2021 | US 2022/0018617 entire text, all drawings | | A1 | |
| JP | 2002-129019 | A | 09 May 2002 | US 2002/0077439 entire text, all drawings | | A1 | |
| JP | 2021-086887 | A | 03 June 2021 | (Family: none) | | | |
| JP | 2020-128463 | A | 27 August 2020 | US 2022/0127500 entire text, all drawings | | A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005042096 A